# EUROPEAN PATENT APPLICATION

(11) **EP 4 517 802 A1**
(43) Date of publication of application: **05.03.2025**
(21) Application number: 22939802.9
(22) Date of filing: 14.10.2022
(51) Int. Cl.: H01L 21/67, H01L 21/68, H01L 21/306

(54) **DEVICE AND METHOD FOR CALIBRATING OPERATION POSITIONS OF POLISHING HEAD AND LOADING AND UNLOADING PLATFORM**

(30) Priority: 24.04.2022 CN 202210432780
(71) Applicant: Hangzhou Sizone Electronic Technology Inc., Hangzhou Zhejiang 311305 (CN)
(72) Inventor: XU, Xiaoyu, Hangzhou, Zhejiang 311300 (CN); ZHOU, Gaoxiang, Hangzhou, Zhejiang 311300 (CN); CAI, Ningyuan, Hangzhou, Zhejiang 311300 (CN)
(74) Representative: Becker, Eberhard
(86) International application number: PCT/CN2022/125492
(87) International publication number: WO 2023/206982

(57) **Abstract**

Disclosed in the present invention is a device for calibrating operation positions of a polishing head and a loading and unloading platform. The device comprises: a loading and unloading platform capable of reciprocating along a straight-line trajectory; a polishing head capable of rotating circumferentially, a rotation trajectory of the polishing head and the straight-line trajectory at least having one intersection point; a sensor assembly, which is configured to monitor the change in the distance between an outer edge of the polishing head and a sensor, and which comprises a sensor that can measure the distance at least at two radial ends of the loading and unloading platform; and a determination unit, which is configured to output the minimum straight-line distance between the outer edge of the polishing head and the sensor that is monitored by the sensor assembly, so as to determine whether the central axis of the polishing head coincides with the central axis of the loading and unloading platform. Further disclosed in the present invention is a method for calibrating operation positions of a polishing head and a loading and unloading platform. The present invention has high calibration efficiency and low requirements for the mounting position of the sensor, and the measurement error thereof is small.

## Description

### BACKGROUND OF THE INVENTION

### 1. Technical Field

The invention relates to the technical field of semiconductor integrated circuit chip manufacturing, and particularly to a device and method for calibrating working positions of a polishing head and a transfer station.

### 2. Description of Related Art

Chemical mechanical planarization (CMP) equipment usually comprises a semiconductor equipment front end module (EFEM), a cleaning unit and polishing unit. The EFEM mainly comprises a wafer box, a wafer transfer manipulator and an air purification system. The cleaning unit mainly comprises different quantities of megasonic cleaning components, scrubber cleaning components, drying components and devices for transferring wafers between the components. The polishing unit usually comprises a polishing platen, a polishing pad, a polishing head, a polishing arm, a dresser and a polishing slurry arm, and each component is arranged on the platen at positions specified by the process layout. It is found from actual wafer processing that the spatial arrangement of the polishing units and cleaning and wafer transportation modules has a great influence on the overall polishing throughput of the CMP equipment. The transfer of wafers between the polishing units and other components and between the polishing units usually depends on a transfer station or devices with similar functions.

An existing polishing module comprises two columns of polishing unit arrays, each column of polishing units comprises one or more groups of polishing units, transfer stations corresponding to the two columns of polishing unit arrays are longitudinally arranged in a column direction of the polishing unit arrays, and a working part of a wafer transfer module is directly above the transfer stations arranged in the longitudinal direction, enabling the transfer of wafers between other loading/unloading areas and the transfer stations, as well as between the transfer stations. Each transfer station serves two opposing polishing units. The multiple groups of polishing units, the wafer transfer module and the transfer stations can collaborate with each other to achieve efficient wafer circulation throughout the entire polishing unit array, resulting in high polishing throughput. Moreover, each column of polishing units can be flexibly increased or decreased according to process requirements or maintenance needs, further enhancing the throughput. As the number of polishing units increases, the manual calibration difficulty and workload for wafer transfer stations also increase.

Chinese Patent No. CN110411344B discloses a calibration method, a calibration device, a calibration system and electronics, which requires four distance values to realize alignment. Moreover, the four distance values solely serve the purpose of aligning a polishing head with a fixed transfer station by rotating the polishing head. The alignment of the transfer station itself is not mentioned. The device is complicated, and low in alignment efficiency, and cannot realize the alignment of the transfer station. In addition, four sensors generate a large amount of detection data, and there are also complex calculations, resulting in a long alignment time.

### BRIEF SUMMARY OF THE INVENTION

In order to overcome the shortcomings of the prior art, the invention provides a device and method for calibrating working positions of a polishing head and a transfer station. The device has a simple structure and is easy to use.

The technical scheme adopted by the invention to solve the technical problems is as follows: a device for calibrating working positions of a polishing head and a transfer station comprises:
a transfer station capable of reciprocating along a linear trajectory;
a polishing head capable of rotating in a circumferential direction, with a rotational trajectory intersecting with the linear trajectory at least once;
a sensor assembly used for monitoring the change of a distance between an outer edge of the polishing head and a sensor, comprising the sensor, and capable of measuring the distance at least at two radial ends of the transfer station; and
a determining unit used for outputting a minimum linear distance between the outer edge of the polishing head and the sensor monitored by the sensor assembly to determine whether central axes of the polishing head and the transfer station coincide.

Further, there are at least two sensors which are arranged at the two radial ends of the transfer station; or there is one sensor which is capable of moving to the two radial ends around an outer edge of the transfer station.

Further, in a case where the number of the sensors is at least two, the sensors are arranged in an extending direction of the linear trajectory.

Further, the determining unit is used for outputting a minimum value of the sum of the distances between the outer edge of the polishing head and the sensor monitored by the sensor assembly, or/and outputting a minimum value of the difference between the distances between the outer edge of the polishing head and the sensor monitored by the sensor assembly, so as to determine whether the central axes of the polishing head and the transfer station coincide.

Further, the determining unit is used for comparing a minimum value of the sum of the distances between the outer edge of the polishing head and the sensor monitored by the sensor assembly with a set value, or/and comparing a minimum value of the difference between the distances between the outer edge of the polishing head and the sensor monitored by the sensor assembly with a set value, so as to determine whether the central axes of the polishing head and the transfer station coincide.

Further, the sensor assembly further comprises a receiving groove arranged on the transfer station and a fixed base connected with the sensor, and the fixed base and the receiving groove are detachably connected.

Further, a longitudinal section of the receiving groove is U-shaped, a transverse section of the fixed base is I-shaped, and a necking section of the fixed base is inserted into a notch of the receiving groove from top to bottom.

Further, the sensor is a distance measuring sensor, and there are two in total.

Further, the transfer station is driven by a support to reciprocate along the linear trajectory, and the polishing head is driven by a polishing head swing arm to rotate in the circumferential direction.

The invention further discloses a method for calibrating working positions of a polishing head and a transfer station, comprising the following steps:
making the polishing head rotate in a circumferential direction along a rotational trajectory;
making the transfer station reciprocate along a linear trajectory;
aligning the polishing head; and
aligning the transfer station;
wherein aligning the polishing head and aligning the transfer station are performed successively or simultaneously.

Further, in the step of aligning the polishing head which is performed first, a sensor assembly detects that the sum of distances between an outer edge of the polishing head and a sensor reaches a minimum value; and in the step of aligning the transfer station which is performed subsequently, the sensor assembly detects that the difference between the distances between the outer edge of the polishing head and the sensor reaches a minimum value.

Further, in the step of aligning the transfer station which is performed first, the sensor assembly detects that the sum of the distances between the outer edge of the polishing head and the sensor reaches a minimum value; and in the step of aligning the polishing head which is performed subsequently, the sensor assembly detects that the difference between the distances between the outer edge of the polishing head and the sensor reaches a minimum value.

Further, when aligning the polishing head and aligning the transfer station are performed successively, the polishing head is aligned first, and then the transfer station is aligned.

Further, the method also comprises the following step:
determining the rotational trajectory of the polishing head, and making the polishing head swing within an angular range that allows the sensors at two ends of the transfer station to display readings.

Further, the method also comprises the following step:
before determining the rotational trajectory of the polishing head, moving the transfer station to a position below the polishing head along a linear trajectory.

Further, the method comprises the following steps:
manually moving the transfer station and the polishing head close to each other;
determining the rotational trajectory of the polishing head, taking an angular range that allows the sensors at two ends of the transfer station to display readings as a swinging range of the polishing head, and defining the readings of the two sensors relative to the edge of the polishing head as L1 and L2 respectively;
setting a step size of the polishing head and randomly selecting a rotating direction of the polishing head;
making the polishing head rotate according to the set step size and direction, controlling the polishing head to rotate in the opposite direction in a case where the value of L1+L2 becomes larger, keeping the moving direction unchanged in a case where the value of L1+L2 becomes smaller, until the value of L1+L2 becomes larger again, controlling the polishing head to rotate in the opposite direction by one step, and recording a position of the polishing head at this point as a position where the polishing head is aligned;
setting a step size of the transfer station and randomly selecting a moving direction of the transfer station;
making the transfer station move according to the set step size and direction, controlling the transfer station to move in the opposite direction in a case where the absolute value of L1-L2 becomes larger, keeping the moving direction unchanged in a case where the absolute value of L1-L2 becomes smaller, until the absolute value of L1-L2 becomes larger again, controlling the transfer station to move in the opposite direction by one step, and recording a position of the transfer station at this point as a position where the transfer station is aligned; and
ending the correction process when central axes of the polishing head and the transfer station coincide.

Further, the sensors are arranged at two radial ends of the transfer station; or the sensors are arranged at two radial ends of the transfer station in an extending direction of the linear trajectory; or the sensors are arranged at two radial ends of the transfer station along a direction perpendicular to the linear trajectory.

Further, the method comprises the following steps:
manually moving the transfer station and the polishing head close to each other;
determining the rotational trajectory of the polishing head, taking an angular range that allows the sensors at two ends of the transfer station to display readings as a swinging range of the polishing head, and defining the readings of the two sensors relative to the edge of the polishing head as L1 and L2 respectively;
setting a step size of the transfer station and randomly selecting a moving direction of the transfer station;
making the transfer station move according to the set step size and direction, controlling the transfer station to move in the opposite direction in a case where the value of L1+L2 becomes larger, keeping the moving direction unchanged in a case where the value of L1+L2 becomes smaller, until the value of L1+L2 becomes larger again, controlling the transfer station to move in the opposite direction by one step, and recording a position of the transfer station at this point as a position where the transfer station is aligned; and
setting a step size of the polishing head and randomly selecting a rotating direction of the polishing head;
making the polishing head rotate according to the set step size and direction, controlling the polishing head to rotate in the opposite direction in a case where the absolute value of L1-L2 becomes larger, keeping the moving direction unchanged in a case where the absolute value of L1-L2 becomes smaller, until the absolute value of L1-L2 becomes larger again, controlling the polishing head to rotate in the opposite direction by one step, and recording a position of the polishing head at this point as a position where the polishing head is aligned;
ending the correction process when central axes of the polishing head and the transfer station coincide.

Further, the method comprises the following steps:
manually moving the transfer station and the polishing head close to each other;
determining the rotational trajectory of the polishing head, taking an angular range that allows the sensors at two ends of the transfer station to display readings as a swinging range of the polishing head, and defining the readings of the two sensors relative to the edge of the polishing head as L1 and L2 respectively;
setting a step size of the transfer station, randomly selecting a moving direction of the transfer station, and making the transfer station move according to the set step size and direction;
setting a step size of the polishing head, randomly selecting a rotating direction of the polishing head, and making the polishing head rotate according to the set step size and direction; and
making the transfer station and the polishing head move synchronously, and ending the correction process when central axes of the polishing head and the transfer station coincide;
wherein in a case where the polishing head moves before the transfer station, a position where L1+L2 reaches its minimum value is a position where the polishing head is aligned, and a position where the absolute value of L1-L2 reaches its minimum value is a position where the transfer station is aligned; and
in a case where the transfer station moves before the polishing head, a position where L1+L2 reaches its minimum value is a position where the transfer station is aligned, and a position where the absolute value of L1-L2 reaches its minimum value is a position where the polishing head is aligned.

In the invention, the sensor assembly is installed on the transfer station; when the polishing head is located in the sensor detection range of the transfer station, a controller will execute an alignment program to control the swing of the polishing head and the linear motion of the transfer station in the X direction until the polishing head and the transfer station are aligned, that is, the linear motion trajectory and the arc motion trajectory intersect, and the position of the polishing head and the transfer station is automatically recorded and set as a wafer loading and unloading position; and then the sensor assembly is dismounted and installed on other transfer stations to finish the calibration of each wafer loading and unloading position in turn, and after the calibration is completed, the sensor assembly is removed to end the alignment of the CMP equipment.

The invention has the following beneficial effects: (1) the calibration efficiency is high, and alignment in a complex alignment situation is realized with fewer sensors, a smaller data size and an improved data processing method; (2) the accurate positioning of the sensors and the appropriate selection of the calibration method result in high calibration precision, with minimal requirements for sensor installation positions; (3) by utilizing a determining mechanism that is based on the minimization of the sum of the distances between the outer edge of the polishing head and the sensor and the difference between the distances between the outer edge of the polishing head and the sensor for the determining unit, the detection errors are minimized, and this mechanism proves to be more accurate than the traditional equidistant determining approach; (4) the sensor assembly can be easily assembled and disassembled, and the calibration algorithm can be integrated into software for one-click calibration, thus realizing user-friendly operation; and (5) both the transfer station and the polishing head can move, with the former following a linear trajectory and the latter following an arc trajectory, allowing for swift and accurate calibration even in challenging scenarios.

### BRIEF DESCRIPTION OF THE DRAWINGS

Fig. 1 is a structural diagram of a device of the invention.
Fig. 2 is a structural diagram of a transfer station of the invention.
Fig. 3 is a partial structural diagram of a sensor assembly of the invention.
Fig. 4 is a partial structural diagram of a sensor assembly of the invention, receiving groove not shown.
Fig. 5 is a device layout diagram in a first embodiment of the invention, in which sensors are arranged along a linear trajectory.
Fig. 6 is a diagram of an alignment process in a first embodiment of the invention.
Fig. 7 is a device layout diagram in a second embodiment of the invention, in which sensors are arranged along a radial direction of a transfer station only.
FIG. 8 is a diagram of an alignment process in a second embodiment of the invention.
Fig. 9 is a device layout diagram in a third embodiment of the invention, in which sensors are arranged in a direction perpendicular to a linear trajectory.
FIG. 10 is a diagram of an alignment process in a third embodiment of the invention.
Fig. 11 is a first diagram of an alignment process in a fourth embodiment of the invention, in which one polishing head and two transfer stations are aligned.
FIG. 12 is a second diagram of an alignment process in a fourth embodiment of the invention, in which one transfer station and two polishing heads are aligned.

### DETAILED DESCRIPTION OF THE INVENTION

To allow those skilled in the art to have a better understanding of the scheme of the invention, the technical scheme in the embodiments of the invention will be clearly and completely described below in combination with attached drawings. Obviously, the described embodiments are only illustrative ones, and are not all possible ones. Based on the embodiments of the invention, all other embodiments obtained by those of ordinary skill in the art without creative labor should belong to the scope of protection of the invention.

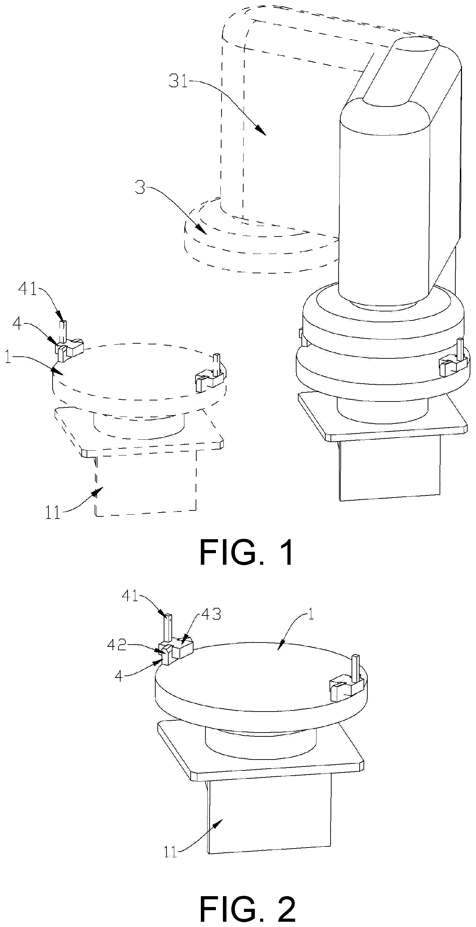

As shown in Figs. 1-5, a device for calibrating working positions of a polishing head and a transfer station comprises a transfer station 1 capable of reciprocating along a linear trajectory 2, a polishing head 3 capable of rotating in a circumferential direction, a sensor assembly 4 at least partially arranged on the transfer station 1, and a determining unit.

In this embodiment, the transfer station 1 is driven by a support 11 to reciprocate along the linear trajectory 2, and the polishing head 3 is driven by a polishing head swing arm 31 to rotate in the circumferential direction.

The circumferential rotational trajectory 5 of the polishing head 3 intersects with the linear trajectory 2 at least once. The sensor assembly 4 comprises at least two sensors 41 arranged at two radial ends of the transfer station 1, which are used for monitoring the change of a distance between an outer edge of the polishing head 3 and the sensor 41. That is, the sensor 41 is a distance measuring sensor.

Of course, there may be only one sensor 41 which can move around an outer edge of the transfer station 1 for half a circle, thus reaching the positions at the two radial ends of the transfer station 1 for distance measurement.

The two sensors 41 are not only arranged along the radial direction of the transfer station 1, but also arranged in an extending direction of the linear trajectory 2.

The determining unit is used for outputting a minimum linear distance between the outer edge of the polishing head 3 and the sensor 41 monitored by the sensor assembly 4, so as to determine whether central axes of the polishing head 3 and the transfer station 1 coincide. The determining unit outputs a result when the polishing head 3 and the transfer station 1 are in a moving state, which can be that either only the polishing head 3 is moving while the transfer station 1 is not moving, or only the transfer station 1 is moving while the polishing head 3 is not moving, or both the polishing head 3 and the transfer station 1 are moving.

The minimum linear distance between the outer edge of the polishing head 3 and the sensor 41 output by the determining unit may be a minimum value of the sum of the distances between the outer edge of the polishing head 3 and the sensor 41 monitored by the sensor assembly 4; or may be a minimum value of the difference between the distances between the outer edge of the polishing head 3 and the sensor 41 monitored by the sensor assembly 4. Alternatively, the determining unit may output both the minimum value of the sum of the distances between the outer edge of the polishing head 3 and the sensor 41 and the minimum value of the difference between the distances between the outer edge of the polishing head 3 and the sensor 41. The ultimate goal is to determine whether the central axes of the polishing head 3 and the transfer station 1 coincide, so as to realize alignment.

A non-zero minimum value can potentially result in an infinite loop. Therefore, a predetermined value can be defined, and the minimum value of the sum of the distances between the outer edge of the polishing head 3 and the sensor 41 is compared with the predetermined value; and if the difference between the two is within an acceptable range, the correction process is stopped, and it is determined that the central axes of the polishing head and the transfer station coincide. Similarly, a predetermined value is defined, and the minimum value of the difference between the distances between the outer edge of the polishing head 3 and the sensor 41 is compared with the predetermined value; and if the difference between the two is within an acceptable range, the correction process is stopped, and it is determined that the center axes of the polishing head and the transfer station coincide.

As shown in Figs. 2-4, in order to facilitate the installation of the sensor 41, the sensor assembly 4 further comprises a receiving groove 42 fixedly arranged on the transfer station 1, and a fixed base 43 which can be connected with the sensor 41, and the fixed base 43 is detachably connected with the receiving groove 42. Specifically, a longitudinal section of the receiving groove 42 is U-shaped, that is, a notch 421 is formed, and a transverse section of the fixed base 43 is I-shaped, that is, the fixed base 43 has a necking section 431, which can be inserted into the notch 421 of the receiving groove 42 from top to bottom. In this way, the fixed base 43 will not move relative to the receiving groove 42 in the horizontal direction, marking the completion of assembly.

A method for calibrating working positions of a polishing head and a transfer station comprises the following steps:
moving the transfer station 1 to a position below the polishing head 2 along a linear trajectory, which can be done manually;
determining a rotational trajectory 5 of the polishing head 3, making the polishing head 3 swing within an angular range that allows sensors 41 at two ends of the transfer station 1 to display readings, recording a starting position and an ending position of the swing of the polishing head 3, and taking the area between the starting position and ending position as the rotational trajectory 5 of the polishing head 3, that is, the initial position of the polishing head 3 falls within the rotational trajectory 5, or within the swinging range;
making the polishing head 3 rotate in a circumferential direction along a rotational trajectory 5;
making the transfer station 1 reciprocate along a linear trajectory 2;
aligning the polishing head 3; and
aligning the transfer station 1;
wherein aligning the polishing head 3 and aligning the transfer station 1 are performed successively or simultaneously.

Aligning the polishing head 3 can be performed first, followed by the alignment step for the transfer station 1; in this case, in the step of aligning the polishing head 3, a sensor assembly 4 detects that the sum of the distances between an outer edge of the polishing head 3 and the sensor 41 reaches a minimum value; and in the step of aligning the transfer station 1, the sensor assembly 4 detects that the difference between the distances between the outer edge of the polishing head 3 and the sensor 41 reaches a minimum value.

Alternatively, aligning the transfer station 1 can be performed first, followed by the alignment step for the polishing head 3; in this case, in the step of aligning the transfer station 1, the sensor assembly 4 detects that the sum of the distances between the outer edge of the polishing head 3 and the sensor 41 reaches a minimum value; and in the step of aligning the polishing head 3, the sensor assembly 4 detects that the difference between the distances between the outer edge of the polishing head 3 and the sensor 41 reaches a minimum value.

### Embodiment 1

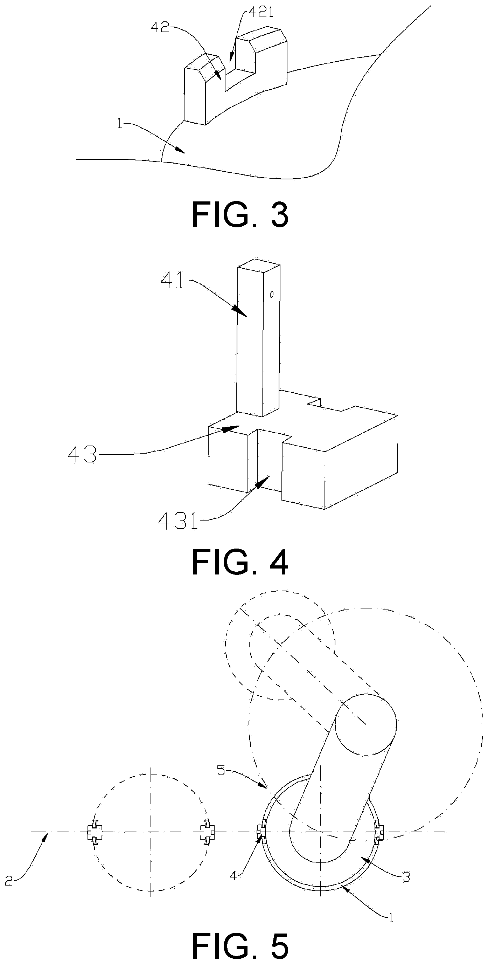

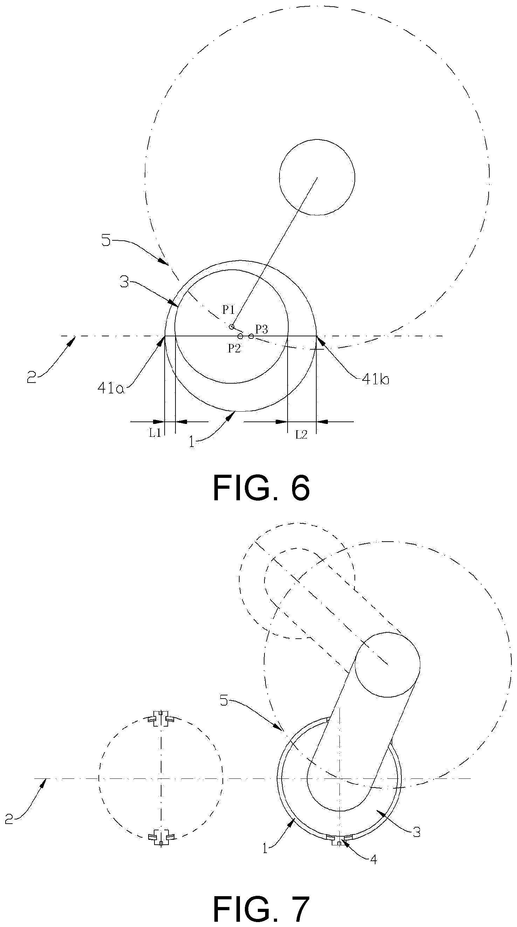

As shown in Figs. 5 and 6, there are two sensors 41 which are not only arranged along the radial direction of the transfer station 1, but also arranged in an extending direction of the linear trajectory 2.

A method for calibrating working positions of a polishing head and a transfer station comprises the following steps:
mounting a sensor assembly 4 onto the transfer station 1, manually moving the transfer station 1 and the polishing head 3 close to each other, and calibrating the reading of a sensor 41;
determining a rotational trajectory 5 of the polishing head 3, taking an angular range that allows the sensors 41 at two ends of the transfer station 1 to display readings as a swinging range of the polishing head 3, recording a starting position and an ending position, and defining the readings of the two sensors 41 relative to the edge of the polishing head 3 as L1 and L2 respectively; in other words, manually roughly adjusting the polishing head 3 and the transfer station 1 so that the polishing head 3 and the transfer station 1 reach the adjustment range; that is, a circular center of the polishing head 3 is located at P1, a circular center of the transfer station 1 is located at P2, one sensor 41a is within the detection range and has a reading L1, and the other sensor 41b is within the detection range and has a reading L2;
setting an appropriate step size of the polishing head 3, which is related to sensor accuracy and set alignment accuracy, and randomly selecting a rotating direction of the polishing head 3;
making the polishing head 3 rotate according to the set step size and direction, controlling a motor to make the polishing head 3 move in the opposite direction in a case where the value of L1+L2 becomes larger, keeping the moving direction unchanged in a case where the value of L1+L2 becomes smaller, until the value of L1+L2 becomes larger again, controlling the motor to make the polishing head 3 rotate in the opposite direction by one step, and recording a position of the polishing head 3 at this point as a position where the polishing head is aligned;
setting an appropriate step size of the transfer station 1, which is related to sensor accuracy and set alignment accuracy, and randomly selecting a moving direction of the transfer station;
making the transfer station 1 move according to the set step size and direction, controlling the transfer station 1 to move in the opposite direction in a case where the absolute value of L1-L2 becomes larger, keeping the moving direction unchanged in a case where the absolute value of L1-L2 becomes smaller, until the absolute value of L1-L2 becomes larger again, controlling the transfer station 1 to move in the opposite direction by one step, and recording a position of the transfer station 1 at this point as a position where the transfer station is aligned; and
ending the correction process since at this point, both P1 and P2 have moved to P3 which is the target position, that is, central axes of the polishing head 3 and the transfer station 1 coincide, which marks that the polishing head 3 and the transfer station 1 have been aligned.

### Embodiment 2

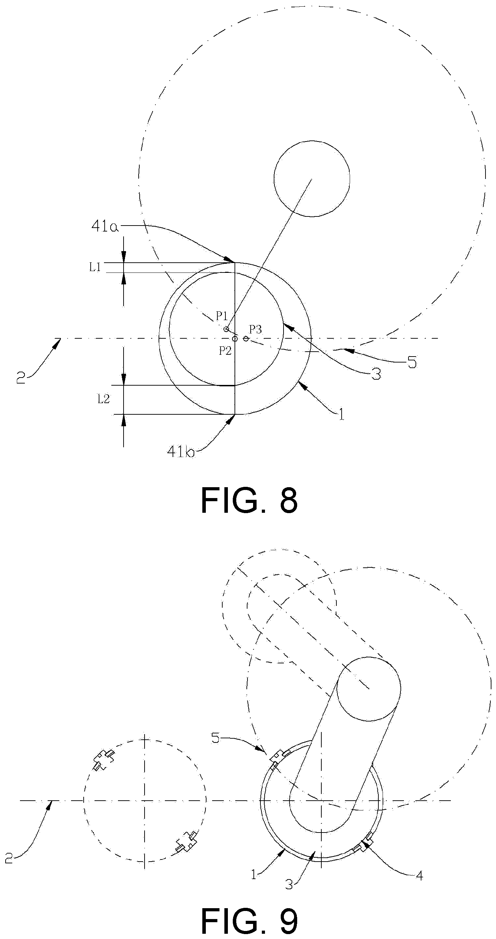

As shown in Figs. 7 and 8, there are two sensors 41 which are not only arranged along the radial direction of the transfer station 1, but also arranged in a direction perpendicular to the linear trajectory 2.

This embodiment adopts the same method for calibrating the working positions of the polishing head and the transfer station as in Embodiment 1, which will not be repeated.

### Embodiment 3

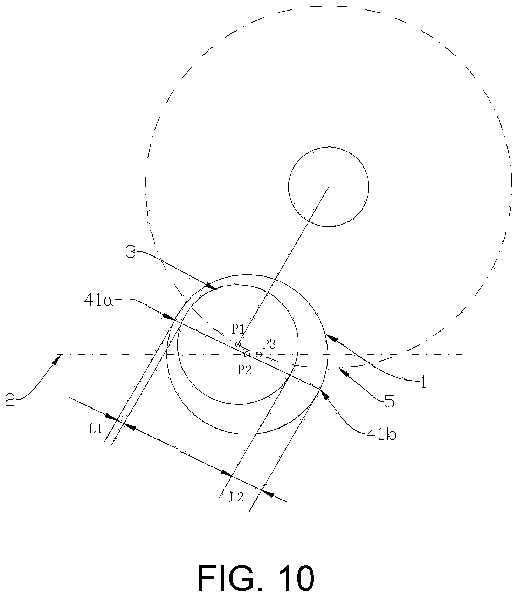

As shown in Figs. 9 and 10, there are two sensors 41 which are only arranged along the radial direction of the transfer station 1, and will not be arranged in a direction perpendicular to the linear trajectory 2 or along an extension direction of the linear trajectory 2.

This embodiment may adopt the same method for calibrating the working positions of the polishing head and the transfer station as in Embodiment 1, or use the following calibration method.

A method for calibrating working positions of a polishing head and a transfer station comprises the following steps:
mounting a sensor assembly 4 onto the transfer station 1, manually moving the transfer station 1 and the polishing head 3 close to each other, and calibrating the reading of a sensor 41;
determining a rotational trajectory 5 of the polishing head 3, taking an angular range that allows the sensors 41 at two ends of the transfer station 1 to display readings as a swinging range of the polishing head 3, recording a starting position and an ending position, and defining the readings of the two sensors 41 relative to the edge of the polishing head 3 as L1 and L2 respectively; in other words, manually roughly adjusting the polishing head 3 and the transfer station 1 so that the polishing head 3 and the transfer station 1 reach the adjustment range; that is, a circular center of the polishing head 3 is located at P1, a circular center of the transfer station 1 is located at P2, one sensor 41a is within the detection range and has a reading L1, and the other sensor 41b is within the detection range and has a reading L2;
setting an appropriate step size of the transfer station 1, which is related to sensor accuracy and set alignment accuracy, and randomly selecting a moving direction of the transfer station;
making the transfer station 1 move according to the set step size and direction, controlling the transfer station 1 to move in the opposite direction in a case where the value of L1+L2 becomes larger, keeping the moving direction unchanged in a case where the value of L1+L2 becomes smaller, until the value of L1+L2 becomes larger again, controlling the transfer station 1 to rotate in the opposite direction by one step, and recording a position of the transfer station 1 at this point as a position where the transfer station is aligned; and
setting an appropriate step size of the polishing head 3, which is related to sensor accuracy and set alignment accuracy, and randomly selecting a rotating direction of the polishing head 3;
making the polishing head 3 rotate according to the set step size and direction, controlling a motor to make the polishing head 3 rotate in the opposite direction in a case where the absolute value of L1-L2 becomes larger, keeping the moving direction unchanged in a case where the absolute value of L1-L2 becomes smaller, until the absolute value of L1-L2 becomes larger again, controlling the motor to make the polishing head 3 rotate in the opposite direction by one step, and recording a position of the polishing head 3 at this point as a position where the polishing head is aligned; and
ending the correction process since at this point, both P1 and P2 have moved to P3 which is the target position, that is, central axes of the polishing head 3 and the transfer station 1 coincide, which marks that the polishing head 3 and the transfer station 1 have been aligned.

### Embodiment 4

In this embodiment, a transfer station 1 and a polishing head 3 move synchronously for dynamic alignment, which is suitable for the situation that two sensors 41 can be arranged at any position along a radial direction of the transfer station 1, or the number of sensors 41 can be increased.

A method for calibrating working positions of a polishing head and a transfer station comprises the following steps:
mounting a sensor assembly 4 onto the transfer station 1, manually moving the transfer station 1 and the polishing head 3 close to each other, and calibrating the reading of a sensor 41;
determining a rotational trajectory 5 of the polishing head 3, taking an angular range that allows the sensors 41 at two ends of the transfer station 1 to display readings as a swinging range of the polishing head 3, recording a starting position and an ending position, and defining the readings of the two sensors 41 relative to the edge of the polishing head 3 as L1 and L2 respectively; in other words, manually roughly adjusting the polishing head 3 and the transfer station 1 so that the polishing head 3 and the transfer station 1 reach the adjustment range; that is, a circular center of the polishing head 3 is located at P1, a circular center of the transfer station 1 is located at P2, one sensor 41a is within the detection range and has a reading L1, and the other sensor 41b is within the detection range and has a reading L2;
setting a step size of the transfer station 1, randomly selecting a moving direction of the transfer station 1, and making the transfer station 1 move according to the set step size and direction;
setting a step size of the polishing head 3, randomly selecting a rotating direction of the polishing head 3, and making the polishing head 3 rotate according to the set step size and direction; and
making the transfer station 1 and the polishing head 3 move synchronously, and ending the correction process when central axes of the polishing head 3 and the transfer station 1 coincide, that is, when both P1 and P2 have moved to P3.

In the above process, in a case where the polishing head 3 moves before the transfer station 1, a position where L1+L2 reaches its minimum value is a position where the polishing head 3 is aligned, and a position where the absolute value of L1-L2 reaches its minimum value is a position where the transfer station 1 is aligned; and
in a case where the transfer station 1 moves before the polishing head 3, a position where L1+L2 reaches its minimum value is a position where the transfer station 1 is aligned, and a position where the absolute value of L1-L2 reaches its minimum value is a position where the polishing head 3 is aligned.

### Embodiment 5

In the above embodiments, one polishing head 3 is aligned with one transfer station 1.

In this embodiment, one polishing head 3 can be aligned with two transfer stations 1, and the alignment method is the same.

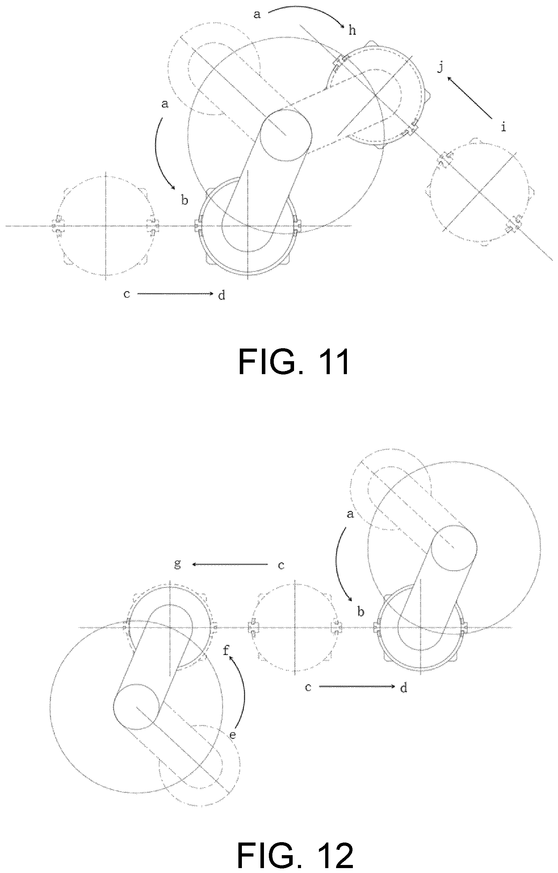

As shown in Fig. 11, after the positions of one transfer station and one polishing head are calibrated to target positions b and d, and the polishing head is coaxial with the transfer station, the polishing head moves from any position a to a position close to a target position h, the other transfer station moves from any position i to a position close to a target position j, and a sensor can detect minimum linear distances between respective installation points and a circular surface of the polishing head. The movement of the transfer station and the polishing head is controlled by an algorithm, and when their positions are calibrated to the target positions h and j, the polishing head and the transfer station are coaxial, indicating that two transfer stations and one polishing head are aligned.

In addition, the polishing head can only be aligned with one of the transfer stations as required.

In addition, the number of transfer stations corresponding to a single polishing head can be more than two, that is, the number of transfer stations to be aligned with a single polishing head can be more than two, the number of transfer stations can be set according to actual requirements, and alignment between the polishing head and one or more transfer stations can be individually accomplished.

It is also possible to align one transfer station 1 with two polishing heads 3 in the same alignment direction.

As shown in Fig. 12, after the positions of one transfer station and one polishing head are calibrated to target positions b and d, and the polishing head is coaxial with the transfer station, the other polishing head moves from any position e to a position close to a target position f, the transfer station moves from any position c to a position close to a target position g, and a sensor can detect minimum linear distances between respective installation points and a circular surface of the polishing head. The movement of the transfer station and the polishing head is controlled by an algorithm, and when their positions are calibrated to the target positions f and g, the polishing head and the transfer station are coaxial, indicating that one transfer station and two polishing devices are aligned.

In addition, the transfer station can only be aligned with one of the polishing heads as required.

In addition, the number of polishing heads corresponding to a single transfer station can be more than two, that is, the number of polishing heads to be aligned with a single transfer station can be more than two, the number of polishing heads can be set according to actual requirements, and alignment between the transfer station and one or more polishing heads can be individually accomplished.

### Embodiment 6

In this embodiment, there is one sensor 41. When being aligned the polishing head 3, the polishing head 3 rotates by one step and then stops rotating, the sensor 41 quickly moves from one end to the other to measure L1 and L2. Of course, it is also possible that the polishing head 3 continues to rotate and the sensor 41 moves to the other end at an extremely fast speed. When the polishing head 3 rotates by one step, the sensor 41 repeats the above steps until the alignment is completed. Other aspects are the same as described in Embodiment 1 and will not be repeated here.

The above specific embodiments are used to explain the invention, but not to limit it. Any modification and change made to the invention within the spirit of the invention and the scope of protection of the claims of the invention fall within the scope of the invention.

## Claims

1. A device for calibrating working positions of a polishing head and a transfer station, comprising:
a transfer station (1) capable of reciprocating along a linear trajectory (2);
a polishing head (3) capable of rotating in a circumferential direction, with a rotational trajectory (5) intersecting with the linear trajectory (2) at least once;
a sensor assembly (4) used for monitoring the change of a distance between an outer edge of the polishing head (3) and a sensor (41), comprising the sensor (41), and capable of measuring the distance at least at two radial ends of the transfer station (1); and
a determining unit used for outputting a minimum linear distance between the outer edge of the polishing head (3) and the sensor (41) monitored by the sensor assembly (4) to determine whether central axes of the polishing head (3) and the transfer station (1) coincide.

2. The device for calibrating the working positions of the polishing head and the transfer station according to claim 1, wherein there are at least two sensors (41) which are arranged at the two radial ends of the transfer station (1); or there is one sensor (41) which is capable of moving to the two radial ends around an outer edge of the transfer station (1).

3. The device for calibrating the working positions of the polishing head and the transfer station according to claim 2, wherein in a case where the number of the sensors (41) is at least two, the sensors are arranged in an extending direction of the linear trajectory (2).

4. The device for calibrating the working positions of the polishing head and the transfer station according to claim 1, wherein the determining unit is used for outputting a minimum value of the sum of the distances between the outer edge of the polishing head (3) and the sensor (41) monitored by the sensor assembly (4), or/and outputting a minimum value of the difference between the distances between the outer edge of the polishing head (3) and the sensor (41) monitored by the sensor assembly (4), so as to determine whether the central axes of the polishing head (3) and the transfer station (1) coincide.

5. The device for calibrating the working positions of the polishing head and the transfer station according to claim 1, wherein the determining unit is used for comparing a minimum value of the sum of the distances between the outer edge of the polishing head (3) and the sensor (41) monitored by the sensor assembly (4) with a set value, or/and comparing a minimum value of the difference between the distances between the outer edge of the polishing head (3) and the sensor (41) monitored by the sensor assembly (4) with a set value, so as to determine whether the central axes of the polishing head (3) and the transfer station (1) coincide.

6. The device for calibrating the working positions of the polishing head and the transfer station according to claim 1, wherein the sensor assembly (4) further comprises a receiving groove (42) arranged on the transfer station (1) and a fixed base (43) connected with the sensor (41), and the fixed base (43) and the receiving groove (42) are detachably connected.

7. The device for calibrating the working positions of the polishing head and the transfer station according to claim 6, wherein a longitudinal section of the receiving groove (42) is U-shaped, a transverse section of the fixed base (43) is I-shaped, and a necking section (431) of the fixed base (43) is inserted into a notch (421) of the receiving groove (42) from top to bottom.

8. The device for calibrating the working positions of the polishing head and the transfer station according to claim 1, wherein the sensor (41) is a distance measuring sensor, and there are two in total.

9. The device for calibrating the working positions of the polishing head and the transfer station according to claim 1, wherein the transfer station (1) is driven by a support (11) to reciprocate along the linear trajectory (2), and the polishing head (3) is driven by a polishing head swing arm (31) to rotate in the circumferential direction.

10. A method for calibrating working positions of a polishing head and a transfer station, comprising the following steps:
making the polishing head rotate in a circumferential direction along a rotational trajectory;
making the transfer station reciprocate along a linear trajectory;
aligning the polishing head; and
aligning the transfer station;
wherein aligning the polishing head and aligning the transfer station are performed successively or simultaneously.

11. The method for calibrating the working positions of the polishing head and the transfer station according to claim 10, wherein in the step of aligning the polishing head which is performed first, a sensor assembly detects that the sum of distances between an outer edge of the polishing head and a sensor reaches a minimum value; and in the step of aligning the transfer station which is performed subsequently, the sensor assembly detects that the difference between the distances between the outer edge of the polishing head and the sensor reaches a minimum value.

12. The method for calibrating the working positions of the polishing head and the transfer station according to claim 10, wherein in the step of aligning the transfer station which is performed first, the sensor assembly detects that the sum of the distances between the outer edge of the polishing head and the sensor reaches a minimum value; and in the step of aligning the polishing head which is performed subsequently, the sensor assembly detects that the difference between the distances between the outer edge of the polishing head and the sensor reaches a minimum value.

13. The method for calibrating the working positions of the polishing head and the transfer station according to claim 10, wherein when aligning the polishing head and aligning the transfer station are performed successively, the polishing head is aligned first, and then the transfer station is aligned.

14. The method for calibrating the working positions of the polishing head and the transfer station according to claim 10, further comprising the following step:
determining the rotational trajectory of the polishing head, and making the polishing head swing within an angular range that allows the sensors at two ends of the transfer station to display readings.

15. The method for calibrating the working positions of the polishing head and the transfer station according to claim 14, further comprising the following step:
before determining the rotational trajectory of the polishing head, moving the transfer station to a position below the polishing head along a linear trajectory.

16. The method for calibrating the working positions of the polishing head and the transfer station according to claim 10, comprising the following steps:
manually moving the transfer station and the polishing head close to each other;
determining the rotational trajectory of the polishing head, taking an angular range that allows the sensors at two ends of the transfer station to display readings as a swinging range of the polishing head, and defining the readings of the two sensors relative to the edge of the polishing head as L1 and L2 respectively;
setting a step size of the polishing head and randomly selecting a rotating direction of the polishing head;
making the polishing head rotate according to the set step size and direction, controlling the polishing head to rotate in the opposite direction in a case where the value of L1+L2 becomes larger, keeping the moving direction unchanged in a case where the value of L1+L2 becomes smaller, until the value of L1+L2 becomes larger again, controlling the polishing head to rotate in the opposite direction by one step, and recording a position of the polishing head at this point as a position where the polishing head is aligned;
setting a step size of the transfer station and randomly selecting a moving direction of the transfer station;
making the transfer station move according to the set step size and direction, controlling the transfer station to move in the opposite direction in a case where the absolute value of L1-L2 becomes larger, keeping the moving direction unchanged in a case where the absolute value of L1-L2 becomes smaller, until the absolute value of L1-L2 becomes larger again, controlling the transfer station to move in the opposite direction by one step, and recording a position of the transfer station at this point as a position where the transfer station is aligned; and
ending the correction process when central axes of the polishing head and the transfer station coincide.

17. The method for calibrating the working positions of the polishing head and the transfer station according to claim 16, wherein the sensors are arranged at two radial ends of the transfer station; or the sensors are arranged at two radial ends of the transfer station in an extending direction of the linear trajectory; or the sensors are arranged at two radial ends of the transfer station along a direction perpendicular to the linear trajectory.

18. The method for calibrating the working positions of the polishing head and the transfer station according to claim 10, comprising the following steps:
manually moving the transfer station and the polishing head close to each other;
determining the rotational trajectory of the polishing head, taking an angular range that allows the sensors at two ends of the transfer station to display readings as a swinging range of the polishing head, and defining the readings of the two sensors relative to the edge of the polishing head as L1 and L2 respectively;
setting a step size of the transfer station and randomly selecting a moving direction of the transfer station;
making the transfer station move according to the set step size and direction, controlling the transfer station to move in the opposite direction in a case where the value of L1+L2 becomes larger, keeping the moving direction unchanged in a case where the value of L1+L2 becomes smaller, until the value of L1+L2 becomes larger again, controlling the transfer station to move in the opposite direction by one step, and recording a position of the transfer station at this point as a position where the transfer station is aligned; and
setting a step size of the polishing head and randomly selecting a rotating direction of the polishing head;
making the polishing head rotate according to the set step size and direction, controlling the polishing head to rotate in the opposite direction in a case where the absolute value of L1-L2 becomes larger, keeping the moving direction unchanged in a case where the absolute value of L1-L2 becomes smaller, until the absolute value of L1-L2 becomes larger again, controlling the polishing head to rotate in the opposite direction by one step, and recording a position of the polishing head at this point as a position where the polishing head is aligned; and
ending the correction process when central axes of the polishing head and the transfer station coincide.

19. The method for calibrating the working positions of the polishing head and the transfer station according to claim 10, comprising the following steps:
manually moving the transfer station and the polishing head close to each other;
determining the rotational trajectory of the polishing head, taking an angular range that allows the sensors at two ends of the transfer station to display readings as a swinging range of the polishing head, and defining the readings of the two sensors relative to the edge of the polishing head as L1 and L2 respectively;
setting a step size of the transfer station, randomly selecting a moving direction of the transfer station, and making the transfer station move according to the set step size and direction;
setting a step size of the polishing head, randomly selecting a rotating direction of the polishing head, and making the polishing head rotate according to the set step size and direction; and
making the transfer station and the polishing head move synchronously, and ending the correction process when central axes of the polishing head and the transfer station coincide;
wherein in a case where the polishing head moves before the transfer station, a position where L1+L2 reaches its minimum value is a position where the polishing head is aligned, and a position where the absolute value of L1-L2 reaches its minimum value is a position where the transfer station is aligned; and
in a case where the transfer station moves before the polishing head, a position where L1+L2 reaches its minimum value is a position where the transfer station is aligned, and a position where the absolute value of L1-L2 reaches its minimum value is a position where the polishing head is aligned.
